# EUROPEAN PATENT APPLICATION

(11) **EP 2 120 256 A2**
(43) Date of publication of application: **18.11.2009**
(21) Application number: 09004621.0
(22) Date of filing: 31.03.2009
(51) Int. Cl.: H01J 61/35

(54) **Optical element, light-emitting device having the same and method of manufacturing the same**

(30) Priority: 16.05.2008 KR 20080045458
(71) Applicant: Samsung Electronics Co., Ltd., Yeongtong-gu Suwon-city, Gyeonggi-do 442-742 (KR)
(72) Inventor: Kim, Hee-Tae, Yongin-si Gyeonggi-do (KR); Nam, Seok-Hyun, Seoul (KR); Lee, Dong-Chin, Cheonan-si, Chungcheongnam-do (KR); Kim, Hyuk-Hwan, Asan-si, Chungcheongnam-do (KR); Kim, Kyung-Min, Asan-si, Chungcheongnam-do (KR); Ryu, So-Jin, Seoul (KR)
(74) Representative: Schmidt, Sven Hendrik

(57) **Abstract**

An optical element includes a light-transmitting structure and a first reflection-prevention layer. The light-transmitting structure has a first surface and a second surface facing the first surface. The first reflection-prevention layer includes a plurality of first light-refractive index buffering particles deposited on the first surface such as the concentration of the particles decreases as the distance from the first surface increases. The first reflection-prevention layer decreases the variation of a light-refractive index from the light-transmitting structure to an air layer to decrease the light reflectance of the first surface. Therefore, the light transmittance of the light-transmitting structure is increased due to the reflection-prevention layer formed on a surface of the light-transmitting structure, so that luminance may be enhanced. Moreover, the reflection-prevention layer may enhance the resistance of the light-transmitting structure to external impacts.

## Description

### BACKGROUND OF THE INVENTION

### 1. Field of the Invention

The present invention relates to an optical element, a light-emitting device having the optical element and a method of manufacturing the optical element. More particularly, the present invention relates to an optical element having improved light usage efficiency, a light-emitting device having the optical element and a method of manufacturing the optical element.

### 2. Description of the Related Art

Generally, a liquid crystal display (LCD) device has a light source for displaying images. An LCD device includes an LCD panel and a backlight assembly providing a rear surface of the LCD panel with light from the backlight assembly.

The light source of the backlight assembly may include a cold cathode fluorescent lamp (CCFL), a light-emitting diode (LED), etc.

In the LCD device, in order to reduce the power consumption of the backlight assembly, and to enhance the longevity and performance of the light source and the LCD panel, it is important that the efficiency of the light source be enhanced. In addition, it is important that the light usage efficiency of members such as an optical sheet be enhanced, which is disposed between the light source and the LCD panel. That is, in the display device, the most essential issue is enhancing the light usage efficiency of the light source, the optical sheet, etc.

Research on the CCFL has been ongoing in relation to enhancing light usage efficiency to reduce power consumption, increasing the luminance of exiting light to realize a high luminance lamp, and decreasing heat generation, etc.

For example, in order to enhance the luminance of the CCFL, a material of a fluorescent substance may be improved, and the pressure of a discharge gas may be changed.

However, there are limits as to how much the luminance of an optical element, such as a light source, an optical sheet, etc., can be increased, and heat generated thereof may not be sufficiently controlled. For example, original light is reflected, transmitted and refracted at boundary surfaces between media; however, reflected light is again absorbed by the light source to increase the temperature of the light source and to decrease the luminance of exiting light.

Therefore, in order to improve the light usage efficiency of the optical elements, a technology capable of effectively decreasing reflected light is required.

### SUMMARY OF THE INVENTION

The present invention provides an optical element having improved light usage efficiency.

The present invention also provides a light-emitting device having the above-mentioned optical element.

The present invention further also provides a method of manufacturing the above-mentioned light-emitting device.

According to one aspect of the present invention, an optical element includes a light-transmitting structure and a first reflection-prevention layer. The light-transmitting structure has a first surface and a second surface facing the first surface. The first reflection-prevention layer includes a plurality of first light-refractive index buffering particles deposited on the first surface, wherein the concentration of the first light-refractive index buffering particles decreases with increasing distance from the first surface. The first reflection-prevention layer changes the rate at which light-refractive index changes at the interface between the light-transmitting structure and an air layer to decrease the light reflectance of the first surface.

The first light-refractive index buffering particles may include at least one material selected from the group consisting of silicon dioxide (SiO₂), aluminum oxide (Al₂O₃), yttrium oxide (Y₂O₃), lanthanum oxide (La₂O₃) and titanium dioxide (TiO₂).

The first reflection-prevention layer may have a thickness of about 50 nm to about 200 nm, and the first light-refractive index buffering particles may have sizes of about 15 nm to about 25 nm.

The optical element may further include second light-refractive index buffering particles including second light-refractive index buffering particles including at least one material selected from the group to be deposited on the second surface, wherein the second light-refractive index buffering particles are more sparsely disposed as the distance from the second surface increases. Thus, the light reflectance of the second surface may be decreased.

The optical element may further include a fluorescent layer formed on the second reflection-prevention layer. The light-transmitting structure may have a shape surrounding a peripheral region of a light-emitting structure emitting light to the second surface.

According to another aspect of the present invention, a light-emitting device includes a light-emitting part, a light-transmitting structure and a first reflection-prevention layer. The light-emitting part generates light. The light-transmitting structure includes a light-incident surface facing the light-emitting part and a light-exiting surface facing to the light-incident surface. The first reflection-prevention layer includes a plurality of first light-refractive index buffering particles deposited on the light-exiting surface, the concentration of the particles decreasing as the distance from the light-exiting surface increases.

The light-transmitting structure may include a lamp tube having the light-incident surface of a tube shape and the light-exiting surface surrounding the light-incident surface. The light-emitting part may include a fluorescent layer formed on the light-incident surface and a discharge gas filling a discharge space defined by the lamp tube.

The light-emitting device may include a second reflection-prevention layer. The second reflection-prevention layer may include a plurality of second light-refractive index buffering particles positioned at an interface between the light-incident surface and the fluorescent layer, wherein the concentration of the second reflection-prevention layer decreases as the distance from the light-incident surface increases.

In an example embodiment of the present invention, each of the first and second light-refractive index buffering particles may include at least one material selected from the group consisting of silicon dioxide (SiO₂), aluminum oxide (Al₂O₃), yttrium oxide (Y₂O₃), lanthanum oxide (La₂O₃) and titanium dioxide (TiO₂).

Each of the first and second reflection-prevention layers may have a thickness of about 50 nm to about 200 nm, and each of the first and second light-refractive index buffering particles have sizes of about 15 nm to about 25 nm.

The light-emitting part may include a light-emitting diode (LED), and the light-transmitting structure may include a lens packaging the LED. The lens has the light-incident surface sealing the LED and the light-exiting surface facing the LED.

The light-emitting part may include a first electrode having a plurality of carbon nanotubes formed on an upper surface of the light-emitting part, a second electrode facing the upper surface, and a fluorescent layer formed to face the carbon nanotube. The light-transmitting structure may include a plate on which the light-incident surface is disposed facing an upper surface of the second electrode.

The light-emitting device may include a second reflection-prevention layer including a plurality of second light-refractive index buffering particles disposed on the light-incident surface, the concentration of the second light-refractive index buffering particles decreasing as the distance from the light-incident surface increases.

In an example embodiment of the present invention, the light-transmitting structure may comprise a sheet of resin material. For example, the light-emitting device may include a second reflection-prevention layer including a plurality of second light-refractive index buffering particles deposited on the light-incident surface, the concentration of the second light-refractive index buffering particles decreasing as the distance from the light-incident surface of the optical sheet increases.

According to another aspect of the present invention, there is provided a method of manufacturing an optical element. In the method, a colloidal solution including colloidal particles is provided. The colloidal solution is solidified so that the concentration of colloidal particles decreases as the distance from a first surface of a light-transmitting structure increases to form a first reflection-prevention layer that changes the light reflectance of the first surface.

To provide a colloidal solution, colloidal particles including at least one material selected from the group consisting of silicon dioxide (SiO₂), aluminum oxide (Al₂O₃), yttrium oxide (Y₂O₃), lanthanum oxide (La₂O₃) and titanium dioxide (TiO₂) that has sizes of 15 nm to about 25 nm may be provided. Then, the colloidal particles are dispersed in alcohol of about 5 weight percent to about 20 weight percent.

To form the first reflection-prevention layer, the light-transmitting structure may be dipped into the colloidal solution. Then, the light-transmitting structure may be removed from the colloidal solution to form a colloidal solution layer on the first surface. Then, the colloidal solution layer formed on the first surface may be dried to solidify the colloidal particles.

A second reflection-prevention layer may be formed on a second surface of the light-transmitting structure facing the first surface. To form the second reflection-prevention layer, another colloidal solution may be solidified on the second surface, which has second light-refractive index buffering particles including at least one material selected from the above group.

According to another aspect of the present invention, there is provided a method of manufacturing a light-emitting device. In the method, a lamp body is dipped into a colloidal solution, which has a lamp tube, a fluorescent layer formed on an interior surface of the lamp tube and discharge gas filled in the lamp tube. Then, the lamp body is removed from the colloidal solution to form a colloidal solution layer on an exterior surface of the lamp tube. Then, the colloidal solution formed on the exterior surface is solidified so that a concentration of colloidal particles decreases as the distance from the exterior surface increases to form a first reflection-prevention layer.

The thickness of the first reflection-prevention layer may be made to be about 50 nm to 200 nm by controlling the speed at which the lamp body is removed from the colloidal solution.

The colloidal solution may be formed, in which the colloidal particles include at least one material selected from the group consisting of silicon dioxide (SiO₂), aluminum oxide (Al₂O₃), yttrium oxide (Y₂O₃), lanthanum oxide (La₂O₃) and titanium dioxide (TiO₂) that has sizes of 15 nm to about 25 nm is dispersed into alcohol of about 5 weight percent to about 20 weight percent.

According to another aspect of the present invention, there is provided a method of manufacturing a light-emitting device. In the method, a lamp tube having two open end portions is dipped into a colloidal solution having a plurality of colloidal particles including at least one material selected from the group consisting of silicon dioxide (SiO₂), aluminum oxide (Al₂O₃), yttrium oxide (Y₂O₃), lanthanum oxide (La₂O₃) and titanium dioxide (TiO₂). Then, the lamp tube is removed from the colloidal solution to form a colloidal solution layer on an exterior surface and an interior surface of the lamp tube, respectively. Then, the colloidal solution layer is solidified so that a concentration of colloidal particles decreases as the distances from the exterior and interior surfaces increase to form a first reflection-prevention layer and a second reflection-prevention layer. Then, a fluorescent layer is formed on the second reflection-prevention layer formed on the interior surface. Then, the lamp tube having the fluorescent layer formed thereon is sealed, and then, a discharge gas is injected into the lamp tube.

A light-emitting device having the optical element and a method of manufacturing the optical element, the light transmittance of the light-transmitting structure and the light-emitting device is increased due to the reflection-prevention layer formed on a surface of the light-transmitting structure, so that luminance may be enhanced. As the light transmittance is increased, heat generation amounts from the light-emitting device is decreased, so that longevity and performance thereof may be enhanced and power consumption may be decreased. Moreover, the reflection-prevention layer may enhance the resistance of the light-transmitting structure to external impacts.

### BRIEF DESCRIPTION OF THE DRAWINGS

The above and other features and advantages of the present invention will become more apparent by describing in detailed example embodiments thereof with reference to the accompanying drawings.

FIG. 1 is a plan view illustrating a light-emitting device according to Embodiment 1 of the present invention;

FIG. 2 is a cross-sectional view taken along a line I-I' of t light-emitting device of FIG. 1;

FIG. 3 is an enlarged cross-sectional view of the optical element of FIG. 2;

FIG. 4 is an enlarged cross-sectional view of the optical element without a reflection-prevention layer;

FIG. 5 is a cross-sectional view of the light-emitting device having a reflection-prevention layer formed on a portion of an exterior surface;

FIG. 6 is a graph showing the luminance of exiting light in accordance with a position of the light-emitting device of FIG. 5;

FIG. 7 is a flowchart illustrating a method of manufacturing the light-emitting device of FIG. 2;

FIGS. 8 and 9 are cross-sectional views illustrating a method of manufacturing a light-emitting device as described with reference to FIG. 7;

FIG. 10 is a cross-sectional view illustrating a light-emitting device according to Embodiment 2;

FIG. 11 is a flowchart illustrating a method of manufacturing the light-emitting device of FIG. 10;

FIGS. 12 and 13 are cross-sectional views illustrating a method of manufacturing a light-emitting device as described with reference to FIG. 11;

FIG. 14 is a cross-sectional view illustrating a light-emitting device according to Embodiment 3;

FIG. 15 is a cross-sectional view illustrating a light-emitting device according to Embodiment 4; and

FIG. 16 is a cross-sectional view illustrating a light-emitting device according to Embodiment 5.

### DETAILED DESCRIPTION OF THE INVENTION

The present invention is described more fully hereinafter with reference to the accompanying drawings, in which example embodiments of the present invention are shown. The present invention may, however, be embodied in many different forms and should not be construed as limited to the embodiments set forth herein. Rather, these embodiments are provided so that this disclosure will be thorough and complete, and will fully convey the scope of the present invention to those skilled in the art. In the drawings, the sizes and relative sizes of layers and regions may be exaggerated for clarity.

It will be understood that when an element or layer is referred to as being "on," "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular example embodiments only and is not intended to be limiting of the present invention. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Example embodiments of the invention are described herein with reference to cross-sectional illustrations that are schematic illustrations of idealized example embodiments (and intermediate structures) of the present invention. As such, variations from the shapes of the illustrations as a result, for example, of manufacturing techniques and/or tolerances, are to be expected. Thus, example embodiments of the present invention should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the present invention.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, the present invention will be explained in detail with reference to the accompanying drawings.

### Example Embodiment 1

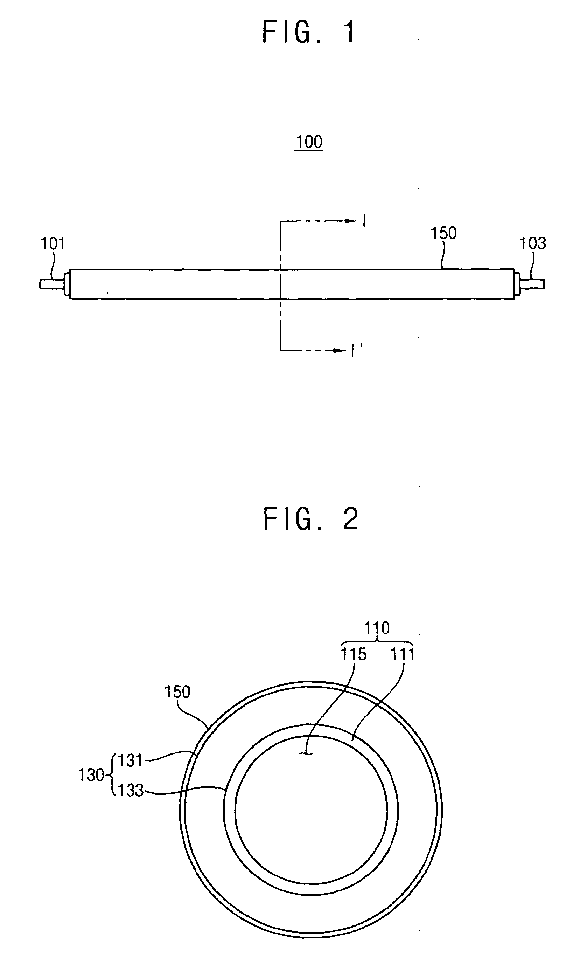

FIG 1 is a plan view illustrating a light-emitting device according to Embodiment 1 of the present invention. FIG 2 is a cross-sectional view taken along a line I-I' of the light-emitting device of FIG 1.

Referring to FIGS. 1 and 2, a light-emitting device 100 in accordance with the present embodiment may be a cold cathode fluorescent lamp (CCFL). The CCFL (hereinafter, a lamp) may be used as a light source of a flat display device such as a liquid crystal display (LCD) device. Thus, the lamp 100 should preferably have low power consumption and high luminance. In the lamp 100 according to the present embodiment, a surface thereof is coated to decrease light reflectance so that the luminance of exiting light may be enhanced.

The lamp 100 includes a light-emitting part 110, a light-transmitting structure, and a reflection-prevention layer 150.

The reflection-prevention layer 150 may be formed on the light-transmitting structure as a film layer. A structure including the light-transmitting structure coupled with the reflection-prevention layer is herein referred to as an optical element.

The light-transmitting structure may include a lamp tube 130 having a rod shape. The lamp tube 130 may be vulnerable to external impacts. The lamp tube 130 includes an interior surface 133 of a cylinder shape and an exterior surface 131 surrounding the interior surface 133 and being spaced apart from the interior surface 133. The interior surface 133 may be a light-incident surface which light generated from the light-emitting part 110 is incident, and the exterior surface 131 may be a light-exiting surface from which the light exits.

The lamp 100 further includes a first electrode part 101 and a second electrode part 103. The first and second electrode parts 101 and 103 seal end portions of the lamp tube 130 to be coupled with the lamp tube 130. One portion of the first and second electrode parts 101 and 103 are disposed in the interior of the lamp tube 130, and another portion of the first and second electrode parts 101 and 103 extend toward the exterior of the lamp tube 130 to receive driving power for driving the lamp 100.

The light-emitting part 110 includes a fluorescent layer 111 and a discharge gas 115.

The fluorescent layer 111 is formed on an interior surface 133 of the lamp tube 130 by a predetermined thickness. When the fluorescent layer 111 receives light such as ultraviolet (UV) radiation, the fluorescent layer 111 irradiates visible rays.

The discharge gas 115 fills in an interior space of the lamp tube 130 that is sealed. The discharge gas 115 includes a gas such as mercury gas, argon gas, etc., that is excited by an electron beam to irradiate UV radiation.

When a high voltage is applied between the first and second electrodes, a discharge is generated between the first and second electrodes, and the discharge gas is excited by the discharge to irradiate UV radiation. The UV radiation exits a fluorescent substance having the fluorescent layer 111, so that visible rays from the fluorescent substance are transmitted through the lamp tube 130 to exit to the exterior.

A portion of the visible rays is reflected by the interior surface 133 and the exterior surface 131 of the lamp tube 130, and the remaining portions of the visible rays are transmitted through the exterior surface 131 to be emitted. Thus, a light amount reflected at the exterior surface 131 and the interior surface 133 of the lamp tube 130 the lamp 100 is preferably small in order to increase an amount of light exiting from the lamp 100.

In this embodiment, the reflection-prevention layer 150 is formed on the exterior surface 131, so that light reflectance of the exterior surface 131 is decreased to enhance the luminance of the lamp 100.

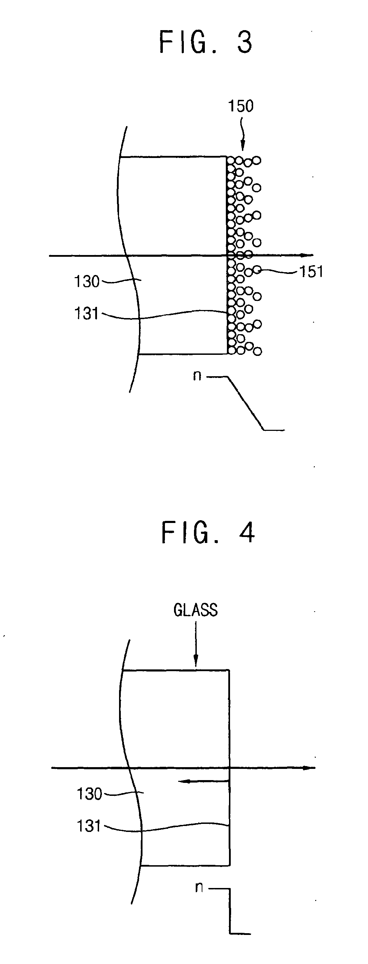

FIG 3 is an enlarged cross-sectional view of the optical element of FIG 2.

Referring to FIG 3, the reflection-prevention layer 150 is formed on an exterior surface 131 of the lamp tube 130. The light-reflective index of the reflection-prevention layer 150 varies depending on the position along a thickness of the reflection-prevention layer 150. As distance between the reflection-prevention layer 150 and the exterior surface 131 toward the thickness direction increases (in the direction of the arrow in FIG 3), the light-refractive index may gradually decrease. Here, the meaning of "gradually decrease" is that the light-refractive index generally decreases with increasing distance from the exterior surface 131, and not that the light-refractive index linearly decreases at a constant rate.

The quality and structure of the reflection-prevention layer 150 differs from conventional structure in that there is a gradient of light-refractive index through the thickness of the reflection-prevention layer 150. The light-refractive index gradually decreases with increasing distance from the exterior surface 131 of the lamp tube 130, as described above. The reflection-prevention layer 150 may include a light-refractive index buffering particles 151 in order to have this characteristic.

The light-refractive index buffering particles 151 are deposited on the exterior surface 131 of the lamp tube 130 in a plurality of layers, as shown in FIG 3. The light-refractive index buffering particles 151 become more sparsely disposed with increasing distance from the exterior surface 131 (in the direction shown by the arrow in FIG. 3, herein referred to as the "thickness direction"). That is, the concentration (number of light-refractive index buffering particles 151 per unit volume) of the light-refractive index buffering particles 151 decreases with distance from the exterior surface 131.

Thus, as the distance from the exterior surface 131 in the thickness direction increases, the number of the light-refractive index buffering particles 151 decreases. Hence, the light-refractive index of the reflection-prevention layer 150 generally decreases in the thickness direction.

The lamp tube 130 may include a glass material having a light-refractive index of about 1.45. An air layer may have a light-refractive index of about 1. The reflection-prevention layer 150 may grade the variation of a refraction index between the air layer and the lamp tube 130. A graph showing the gradual variation of the light-refractive index is illustrated in a lower portion of the cross-section view of the optical element as shown in FIG 3.

FIG 4 is an enlarged cross-sectional view of the optical element without a reflection-prevention layer.

Referring to FIG 4, when a reflection-prevention layer 150 is not formed on the exterior surface 131 of the lamp tube 130, there is substantially a step-change in the light-refractive index at the interface between the exterior surface 131 of the lamp tube 130 and an air layer. This step-change is more dramatic than the gradual change that occurs at the same interface when the reflection-prevention layer 150 is disposed between the exterior surface 131 and the air layer. A graph showing the large step-change the light-refractive index (n) is illustrated in the lower portion of the cross-section view of the lamp tube 130 as shown in FIG 4.

When the different mediums of a light-refractive index form a boundary surface, the reflection ratio of light at the interface increases with difference between the light-refractive index of the mediums. Thus, when of the change in the light-refractive index is made more gradual at the interface, the light reflectance may be decreased.

As shown in FIG 4, when the exterior surface of the lamp tube 130 of a glass material directly contacts an air layer, a large amount of light is reflected by the exterior surface 131, so that the reflected light may be absorbed in the interior of the lamp tube 130. Thus, the amount of exiting light generated from the lamp 100 may decrease, leading to lowered luminance.

On the other hand, as shown in FIG 3, the reflection-prevention layer 150 of the lamp 100 of the present invention decreases the rate of change in the refractive index between the lamp tube 130 and an air layer, thereby decreasing light reflectance at the exterior surface 131. Thus, much of the light incident on the exterior surface 131 through the interior surface 133 is transmitted through the exterior surface 131, enhancing the luminance of the lamp 100.

The light-refractive index buffering particles may be formed by solidifying a colloidal solution at the exterior surface 131 of the lamp tube 130. For example, the light-refractive index buffering particles may include at least one selected from the group consisting of silicon dioxide (SiO₂), aluminum oxide (Al₂O₃), yttrium oxide (Y₂O₃), lanthanum oxide (La₂O₃) and titanium dioxide (TiO₂).

When the lamp 100 irradiates visible rays, the visible rays may have a wavelength of about 400 nm to about 700 nm. In order to enhance the effect of the reflection-prevention layer 150 decreasing light reflectance at the exterior surface 131, the light-refractive index buffering particles may have sizes of about 15 nm to about 25 nm. In this embodiment, a term called as the size may be used as a diameter of the light-refractive index buffering particles, a length of a long axis of the light-refractive index buffering particles, etc.

When the size of the light-refractive index buffering particles 151 is less than about 15 nm, the effect that the light-refractive index particles 151 have on light is so small as to be negligible. Thus, at this point, the light reflectance reduction effect may no longer exist.

Moreover, when the size of the light-refractive index buffering particles 151 is more than about 25 nm, much of the light incident on the reflection-prevention layer 150 is dispersed by the light-refractive index buffering particles 151. Thus, the amount of light transmitted through the reflection-prevention layer 150 decreases, and the luminance increasing effect of the lamp 100 may no longer exist.

The reflection-prevention layer 150 is formed on the exterior surface 131 as a film layer, so that the reflection-prevention layer 150 should have a suitable thickness as a reflection-prevention layer. Generally, a thickness "t" of a thin film corresponding to a minimum value will be obtained by a relation ship such as t = λ/(4n). Here, "λ" denotes a wavelength of an incident light, and "n" denotes a light-refractive index of the thin film.

When the thickness of the reflection-prevention layer 150 is calculated based on the facts that the incident light is visible rays, that the light-refractive indexes of the light-refractive index buffering particles 151 and the reflection-prevention layer are non-uniform, and that the thickness of the reflection-prevention layer 150 may be about 50 nm to about 200 nm. That is, when the thickness of the reflection-prevention layer 150 is out of this range, the reflection-prevention layer 150 may no longer make a significant difference.

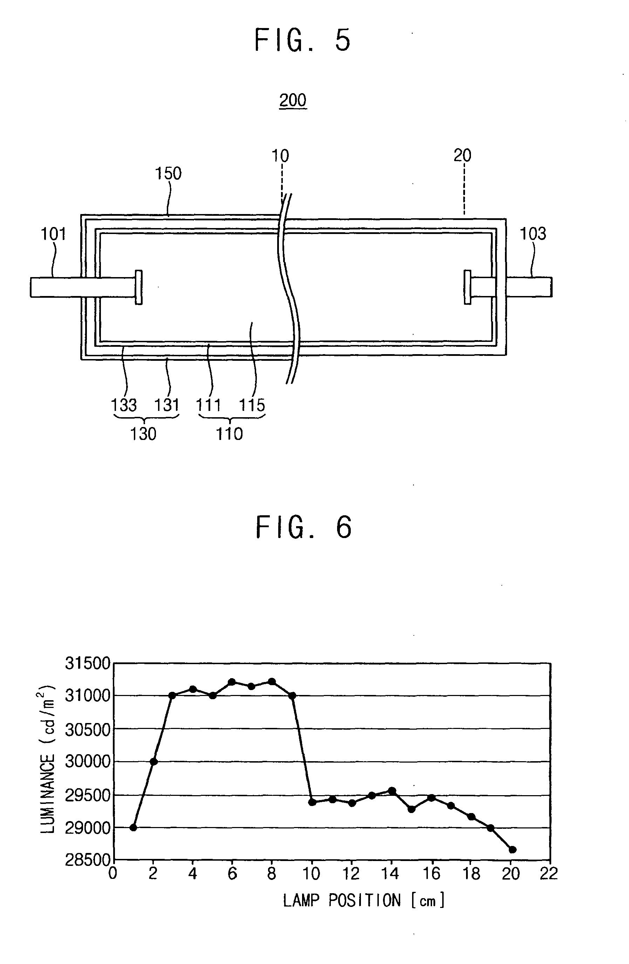

FIG 5 is a cross-sectional view of the light-emitting device having a reflection-prevention layer formed on a portion of an exterior surface.

In order to check the affection of the reflection-prevention layer 150 that is technology characteristics, a sample lamp 200 is manufactured, which the reflection-prevention layer 150 is formed on a portion of the exterior surface 131 of the lamp tube 130.

The sample lamp 200 is substantially the same as the lamp 100 of FIGS. 1 to 4 except for the reflection-prevention layer 150 being formed on an exterior surface 131 corresponding to a substantially half portion toward a length direction of the sample lamp 200 and is not formed on the exterior surface 131 corresponding to the reaming half portion. Thus, identical reference numerals are used in FIG. 5 to refer to components that are the same or like those shown in FIGS. 1 to 4, and thus, a detailed description thereof will be omitted.

FIG 6 is a graph showing the luminance of exiting light in accordance with a position of the light-emitting device of FIG 5.

In FIG 6, X-axis corresponds to a position of the lamp of FIG 5, which is disposed in a length direction, and Y-axis corresponds to the luminance of exiting light generated from the sample lamp 200.

Referring to FIGS. 5 and 6, it is recognized that luminance of the exiting light are about 31,000 cd/m² to about 33,000 cd/m² at an area where the reflection-prevention layer 150 is formed, and luminance of the exiting light is about 29,500 cd/m² to about 29,700 cd/m² at an area where the reflection-prevention layer 150 is not formed.

That is, the lamp 100 according to the present invention has a reflection-prevention layer 150, so that light reflectance is decreased at the exterior surface 131 of the lamp tube 130. As a result, it is recognized that the luminance of the exiting light is enhanced by about 6 percent to about 9 percent.

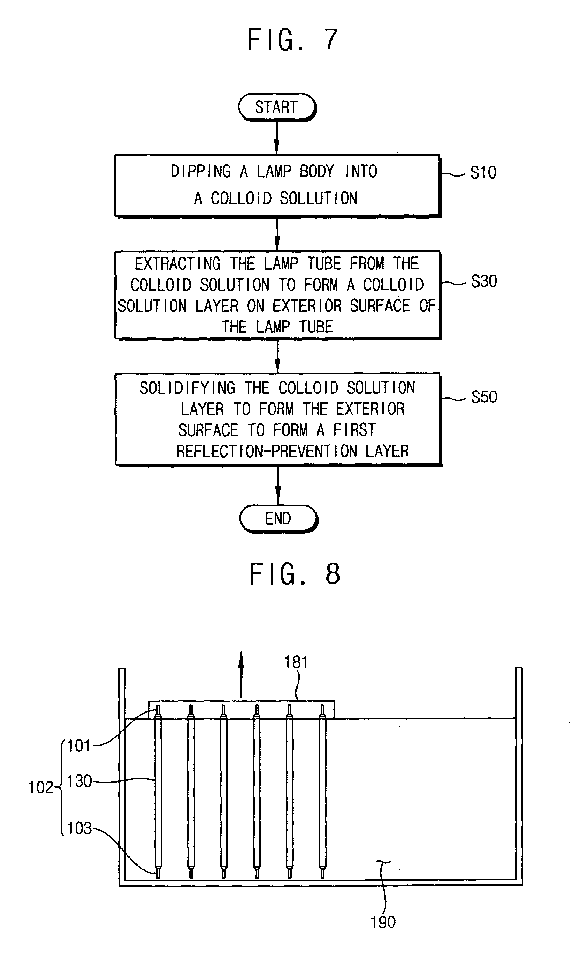

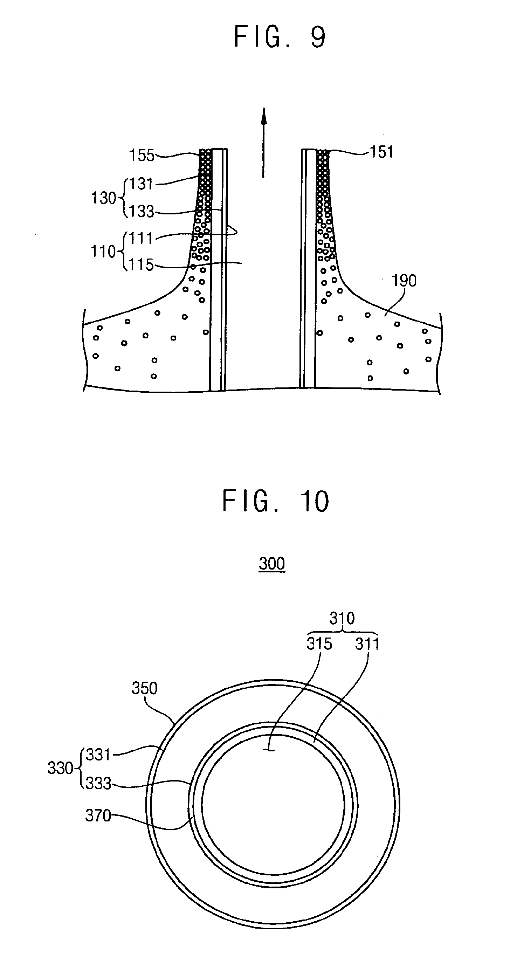

FIG. 7 is a flowchart illustrating a method of manufacturing the light-emitting device of FIG. 2. FIGS. 8 and 9 are cross-sectional views illustrating a method of manufacturing a light-emitting device as described in FIG. 7. That is, FIG. 8 illustrates that the body of the lamp 100 is dipped into a colloidal solution, and FIG. 9 illustrates that a body of the lamp 100 is removed from the colloidal solution.

The light-emitting device 100 according to the present embodiment, that is, the lamp 100, includes the optical element. Thus, a method of manufacturing the lamp 100 uses a method of manufacturing the optical element, and includes the method of manufacturing the optical element as part of the manufacturing process. Thus, an additional description for the method of manufacturing the optical element will be omitted, and the method of manufacturing the optical element among the description of the method of manufacturing the lamp 100 will be described.

Referring to FIG 7, in order to manufacture the lamp 100 as described with reference to FIGS. 1 to 6, a lamp body 102 is dipped into a colloidal solution 190 (step S10).

The lamp body 102 may be manufactured by manufacturing the lamp tube 130 of a straight tube shape, forming the fluorescent layer 111 in the interior surface 133 of the lamp tube 130, sealing end portions of the lamp tube 130 by the first and the second electrode parts 101, 103 (see FIG 1) and filling up the discharge gas in the interior of the lamp tube 130 that is sealed. The method of manufacturing the lamp body 102 is well known, so that further description will be omitted.

Referring to FIG 8, the lamp body 102 fixed to a transferring unit 181 is vertically dipped into the colloidal solution 190.

The colloidal solution 190 may be a colloidal suspension of the light-refractive index buffering particles 151 dispersed in alcohol. The light-refractive index buffering particles may have sizes of about 15 nm to about 25 nm that do not dissolve in the medium in which they are dispersed (e.g., alcohol), so that the light-refractive index buffering particles may be called "colloidal particles." The colloidal particles may include at least one of silicon dioxide (SiO₂) aluminum oxide (Al₂O₃), yttrium oxide (Y₂O₃), lanthanum oxide (La₂O₃) and titanium dioxide (TiO₂).

In the colloidal solution 190, the weight percent of the colloidal particles may be adjusted in accordance with processing conditions. For example, characteristics of the exterior surface 131 of the lamp tube 130, the thickness of the reflection-prevention layer 150, a velocity of the transferring unit 181, etc. may affect the desired weight-% of the colloidal particles. In this embodiment, the colloidal particles may be dispersed in alcohol by about 5 weight percent to about 20 weight percent of the total weight (particles + alcohol) to manufacture the colloidal solution 190.

For example, when silicon oxide (SiO₂) having sizes of about 15 nm to about 20 nm is added to an alcohol solution, a surface of the silicon oxide (SiO₂) may have a negative electric characteristics and the solution of the alcohol solution may have a positive electric characteristics. Thus, the silicon oxide (SiO₂) particles are concentrated to be formed in a homogenous sol state.

Then, when the lamp body 102 is extracted from the colloidal solution 190 to form a colloidal solution layer on an exterior surface 131 of the lamp tube 130 as shown in FIG 9 (step S30).

The thickness of the colloidal solution layer changes in accordance with how fast the lamp body 102 is removed from the liquid. Hence, the thickness of the reflection-prevention layer 150 may be controlled by the speed with which the lamp body 102 is removed from the liquid.

Generally, the film made from the colloid suspension is made thinner as the lamp body 102 is pulled out of the colloidal solution 190 faster. Thus, in order to control the thickness of the reflection-prevention layer 150 to lie between about 50 nm to about 200 nm, the removal speed may be controlled when pulling out the lamp body 102 from the colloidal solution 190.

Then, the colloidal solution 190 formed on the exterior surface 131 is solidified to form a reflection-prevention layer 150 having the colloidal particles that are more sparsely disposed with increasing distance from the exterior surface 131 (step S50).

The colloidal solution layer deposited on the exterior surface 131 is dried at room temperature in a natural state. The colloidal solution layer may be easily dried without high-temperature heating.

For example, the alcohol, which is mixed with the silicon oxide (SiO₂) particles coated on the exterior surface 131 of the lamp tube 130, is evaporated. For example, the silicon oxide (SiO₂) particles having sizes of about 15 nm to about 20 nm are attached with each other by a van der Waals force. Van der Waals force is an attractive force between colloidal particles no more than about 1 µm apart, which is a coupling force between nanosize particles.

The colloidal particles are closely attached to the exterior surface 131 due to mutual attraction between the exterior surface 131 of the lamp tube 130 and the colloidal particles; however, the number of colloidal particles may decrease with increasing distance from the exterior surface 131. For example, the colloidal particles may have a layered structure. That is, as the distance between the colloidal particles and the exterior surface 131 increases, the colloidal particles become more sparsely disposed.

The colloidal particles in the sol state are gelatinized to form the reflection-prevention layer 150, so that the colloidal particles may not be visible. When a surface of the lamp 100 is touched by a finger, a slight roughness may be sensed to indicate the existence of the reflection-prevention layer 150.

According to the optical element, a light-emitting device 100 having the optical element and a method of manufacturing the light-emitting device 100, the light transmittance of the light-transmitting structure and the light-emitting device 100 is increased due to the reflection-prevention layer 150 formed on a surface of the light-transmitting structure, so that luminance may be enhanced. As the light transmittance is increased, heat generation amounts from the light-emitting device 100 is decreased, so that the longevity and performance thereof may be enhanced and power consumption may be decreased. Moreover, the reflection-prevention layer 150 may enhance the resistance of the light-transmitting structure to external impacts.

### Example Embodiment 2

FIG. 10 is a cross-sectional view illustrating a light-emitting device according to Embodiment 2.

Referring to FIG 10, a lamp 300 according to the present embodiment is substantially the same as the lamp 300 of FIGS. 1 to 6 except for a second reflection-prevention layer 370 formed on an interior surface 333 of a lamp tube 330. The optical element according to the present embodiment includes a lamp tube 330, and first and second reflection-prevention layers 350 and 370. Therefore, identical reference numerals are used in FIG 10 to refer to components that are the same or like those shown in FIGS. 1 to 6 and detailed description thereof will be omitted.

In FIG 10, the second reflection-prevention layer 370 is disposed between the interior surface 333 and the fluorescent layer 311. The second reflection-prevention layer 370 includes light-refractive index buffering particles 351 including at least one selected from the group consisting of silicon dioxide (SiO₂), aluminum oxide (Al₂O₃), yttrium oxide (Y₂O₃), lanthanum oxide (La₂O₃) and titanium dioxide (TiO₂). The light-refractive index buffering particles 351 become more sparsely disposed as the distance from the interior surface 333 increases. Thus, light transmittance may be increased by the second reflection-prevention layer 370 and the first reflection-prevention layer at the interior surface 333 and the exterior surface 331, respectively, increasing the luminance of the lamp 300.

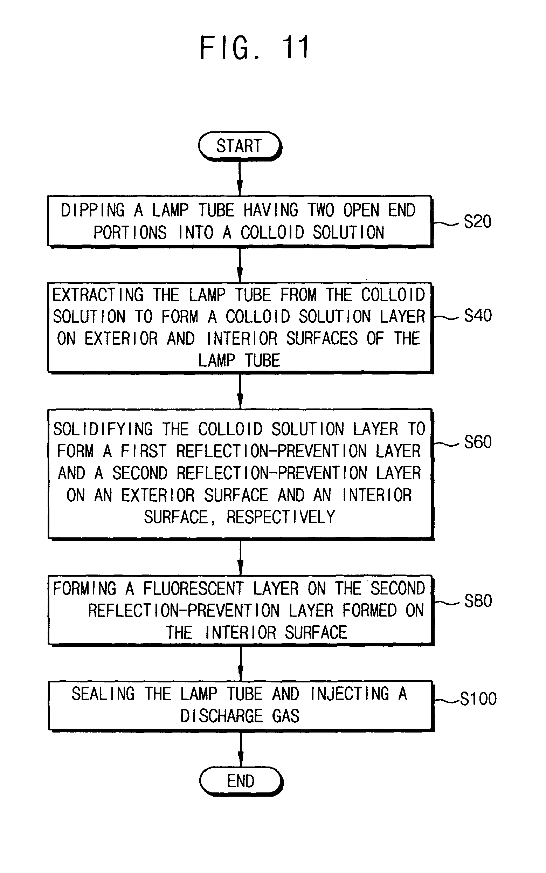

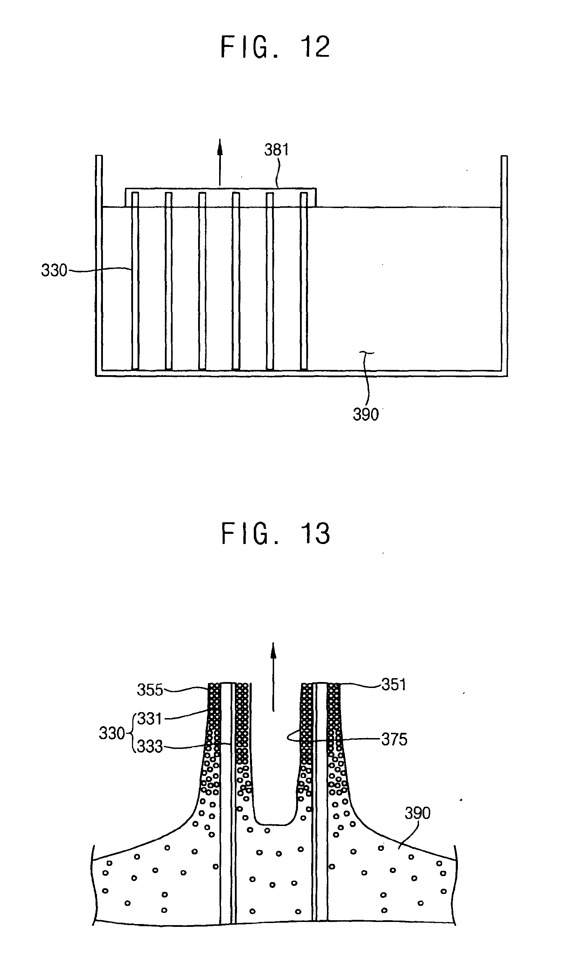

FIG. 11 is a flowchart illustrating a method of manufacturing the light-emitting device of FIG. 10. FIGS. 12 and 13 are cross-sectional views illustrating a method of manufacturing a light-emitting device as described with reference to FIG. 11.

Referring to FIGS. 11 to 13, in order to manufacture the lamp 300 of FIG 10, a colloidal solution 390 is prepared, which has colloidal particles including at least one selected from the group consisting of silicon dioxide (SiO₂), aluminum oxide (Al₂O₃), yttrium oxide (Y₂O₃), lanthanum oxide (La₂O₃) and titanium dioxide (TiO₂).

Then, a lamp tube 330 having two open end portions is dipped into a colloidal solution 390 (step S20). The lamp tube 330 is a straight type tube having two open end portions. When the lamp tube 330 is dipped into the colloidal solution 390, the interior surface 333 and the exterior surface 331 of the lamp tube 330 may contact with the colloidal solution 390.

Then, the lamp tube 330 is lifted out of the colloidal solution 390 to form a plurality of colloidal solution layer 390 on the exterior surface 331 and the interior surface 333 of the lamp tube 330 (step S40). By adjusting the pull-out speed of the lamp tube 330, the thickness of the reflection-prevention layer which will be formed may be controlled.

Additionally, the colloidal solution layer 390 is solidified to form a first reflection-prevention layer 350 and a second reflection-prevention layer having the colloidal particles that become more sparsely disposed as the distance from the exterior surface 331 and the interior surface 333 increases (step S60). The thickness of the first reflection-prevention layer 350 may be substantially equal to that of the second reflection-prevention layer 370, as described in Embodiment 1.

Additionally, a fluorescent layer 311 is formed on the second reflection-prevention layer 370 formed on the interior surface 333 (step S80).

Then, the first and second electrode are formed in the lamp tube 330 having the fluorescent layer 311, and then the lamp tube 330 is sealed with each other. Then, a discharge gas 315 is injected to the interior of the lamp tube 330 to complete the lamp 300 (step S 100).

According to the invention, a lamp 300 having the optical element and a method of manufacturing the lamp 300 include forming the reflection-prevention layer on an interior surface 333 and exterior surface of the lamp tube 330, so that light reflectance may be decreased. This way, the luminance of the lamp 300 may be increased.

### Example Embodiment 3

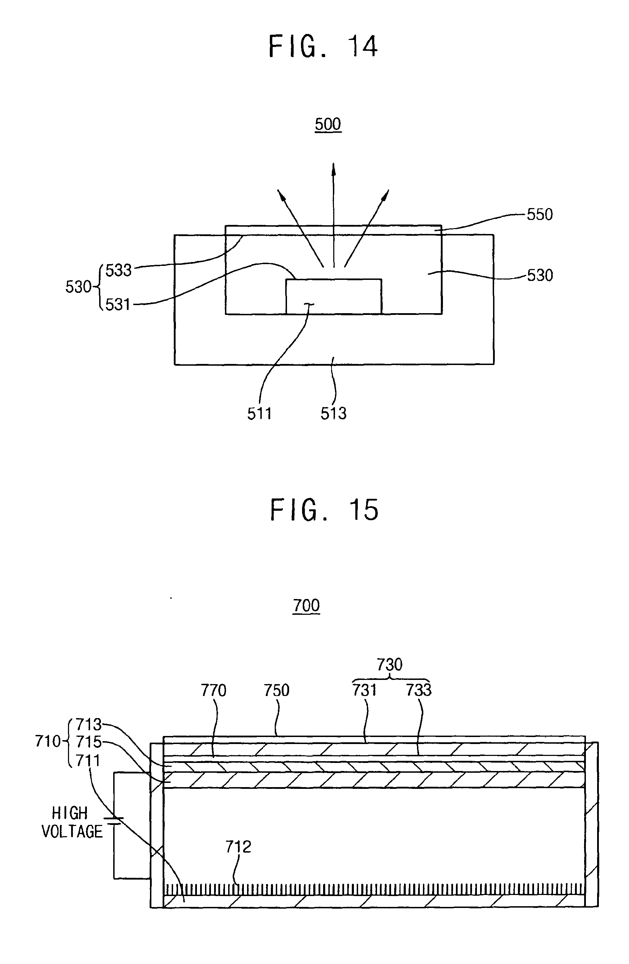

FIG. 14 is a cross-sectional view illustrating a light-emitting device according to Embodiment 3.

A reflection-prevention layer of the light-emitting device 500 according to the present embodiment is similar to that of the light-emitting device 100 as described in Embodiment 1. The light-emitting device 500 includes a light-emitting part and an optical element. The optical element includes a light-transmitting structure and a reflection-prevention layer 550.

In this embodiment, the light-emitting device 500 is a light-emitting diode (LED) package 500, the light-emitting part is an LED chip 511, and the light-transmitting structure is a lens 530 packaging the LED chip 511.

The reflection-prevention layer 550 is formed on an exterior surface 531 of the lens 530. A structure of the reflection-prevention layer 550 is substantially the same as the reflection-prevention layer 150 of FIGS. 1 to 6. Thus, identical reference numerals are used in FIG 14 to refer to components that are the same or like those shown in FIGS. 1 to 6, and thus, a detailed description thereof will be omitted.

In the method of manufacturing an optical element and the method of manufacturing an LED package having the optical element, a colloidal solution is solidified on a surface of the lens 530 to form the reflection-prevention layer 550.

One way of manufacturing the optical element includes dipping the exterior surface 531 of the lens 530 into the colloidal solution, and then pulling out the exterior surface 531 from the colloidal solution. Another way of manufacturing the optical element includes coating the colloidal solution on the exterior surface 531 of the lens 530 by using a device such as a slit nozzle.

The method of manufacturing the LED package except for a process which forms the reflection-prevention layer 550 on the lens 530 is well known, so that further description will be omitted.

According to this embodiment, an amount of exiting light irradiated from the LED chip 511 is increased by the reflection-prevention layer 550 formed on the lens 530. Thus, the luminance of the LED package 500 is increased, and power consumption is decreased. Heat generation amounts may be decreased, thereby enhancing the reliability of the display device.

### Example Embodiment 4

FIG. 15 is a cross-sectional view illustrating a light-emitting device according to Embodiment 4.

A reflection-prevention layer 750 of the light-emitting device 700 according to the present embodiment is similar to that of the light-emitting device 100 as described in Embodiment 1. The light-emitting device 700 includes a light-emitting part 710 and an optical element. The optical element includes a light-transmitting structure 730 and a reflection-prevention layer 750.

In this embodiment, the light-emitting device 700 is a carbon nanotube backlight assembly. The light-emitting part 710 may include a first electrode 711, a second electrode 713 and a fluorescent layer 715.

A plurality of carbon nanotubes 712 is formed on an upper surface of the first electrode 711. The second electrode 713 is disposed to face the upper surface of the first electrode 711.

The fluorescent layer 715 faces the carbon nanotube 712 on a lower surface of the second electrode 713. For example, the light-transmitting structure 730 may have a plate shape which the light-incident surface 733 faces an upper surface of the second electrode 713.

Moreover, the light-emitting device 700 may further include a second reflection-prevention layer 770 formed on the light-incident surface 733 of the light-transmitting structure 730.

The method of manufacturing an optical element according to the present embodiment and the method of manufacturing a carbon nanotube backlight assembly having the optical element are substantially the same as a method of manufacturing a conventional carbon nanotube backlight assembly except for reflection-prevention layers 770 and 750 being formed on the light-incident surface 733 and the light-exiting surface 731 of the light-transmitting structure 730, respectively. Thus, a detailed description thereof will be omitted.

According to the present embodiment, the luminance of light exiting from the carbon nanotube backlight assembly is increased, and power consumption thereof is reduced. Moreover, heat generation amounts from the carbon nanotube backlight assembly may be reduced, so that the reliability thereof may be enhanced.

### Example Embodiment 5

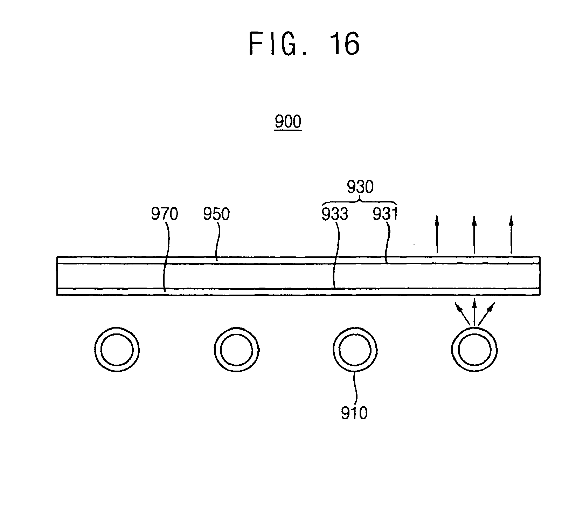

FIG. 16 is a cross-sectional view illustrating a light-emitting device according to Embodiment 5.

Referring to FIG. 16, a reflection-prevention layer 950 of the light-emitting device 900 according to the present embodiment is similar to that of the light-emitting device 100 as described in Embodiment 1. The light-emitting device 900 includes a light-emitting part 910 and an optical element. The optical element includes a light-transmitting structure 930 and a reflection-prevention layer 950.

In this embodiment, the light-emitting device 900 may be a direct-type backlight assembly of a flat panel display device.

The light-transmitting structure 930 of the optical element may be in the form of an optical sheet including a resin material. For example, the light-emitting device 900 may further include a second reflection-prevention layer 970 having a plurality of second light-refractive index buffering particles formed on a light-incident surface 933 of the light-transmitting structure 930 of the optical sheet shape.

According to the present embodiment, the luminance of light exiting from the direct-type backlight assembly is increased, and power consumption thereof is reduced. Moreover, heat generation amounts from the direct-type backlight assembly may be reduced, so that reliability thereof may be enhanced.

In the optical element, a light-emitting device having the optical element and a method of manufacturing the optical element of the present embodiment, luminance of light exiting from the light-emitting device is increased, and power consumption is reduced. Moreover, heat generation from the light-emitting device may be reduced, so that reliability of the light-emitting device may be enhanced and resistance to external impacts may be increased. Therefore, in various light-emitting devices such as a lamp, an LED package, etc., the present invention may be employed in a technology in which light usage efficiency is enhanced to reduce power consumption and heat generation amounts.

The foregoing is illustrative of the present invention and is not to be construed as limiting thereof. Although embodiments of the present invention have been described, those skilled in the art will readily appreciate that many modifications are possible in the example embodiments without materially departing from the novel teachings and advantages of the present invention. Accordingly, all such modifications are intended to be included within the scope of the present invention as defined in the claims. Therefore, it is to be understood that the foregoing is illustrative of the present invention and is not to be construed as limited to the specific example embodiments disclosed, and that modifications to the disclosed example embodiments, as well as other example embodiments, are intended to be included within the scope of the appended claims. The present invention is defined by the following claims, with equivalents of the claims to be included therein.

## Claims

1. An optical element comprising:
a light-transmitting structure having a first surface and a second surface facing the first surface; and
a first reflection-prevention layer comprising a plurality of first light-refractive index buffering particles deposited on the first surface, a concentration of the first light-refractive index buffering particles decreasing with increasing distance from the first surface, the first reflection-prevention layer changing the rate at which light-refractive index changes at the interface between the light-transmitting structure and an air layer to decrease the light reflectance of the first surface.

2. The optical element of claim 1, wherein the first light-refractive index buffering particles include at least one material selected from the group consisting of silicon dioxide (SiO₂), aluminum oxide (Al₂O₃), yttrium oxide (Y₂O₃), lanthanum oxide (La₂O₃) and titanium dioxide (TiO₂).

3. The optical element of claim 2, wherein each of the first reflection-prevention layer has a thickness of about 50 nm to about 200 nm.

4. The optical element of claim 3, wherein each of the first light-refractive index buffering particles have sizes of about 15 nm to about 25 nm.

5. The optical element of claim 2, further comprising a second light-refractive index buffering particles comprising second light-refractive index buffering particles including at least one material selected from the group to be deposited on the second surface,
wherein a concentration of the second light-refractive index buffering particles decreases with increasing distance from the second surface, thereby changing the light reflectance of the second surface.

6. A light-emitting device comprising:
a light-emitting part generating light;
a light-transmitting structure comprising a light-incident surface facing the light-emitting part and a light-exiting surface facing the light-incident surface; and
a first reflection-prevention layer comprising a plurality of first light-refractive index buffering particles deposited on the light-exiting surface, a concentration of the first light-refractive index buffering particles decreasing as the distance from the light-exiting surface increases.

7. The light-emitting device of claim 6, wherein the light-transmitting structure comprises a lamp tube having the light-incident surface of a tube shape and the light-exiting surface surrounding the light-incident surface, and
the light-emitting part comprises a fluorescent layer formed on the light-incident surface and a discharge gas filling a discharge space defined by the lamp tube,
wherein the light-emitting device further comprises a second reflection-prevention layer comprising a plurality of second light-refractive index buffering particles positioned at an interface between the light-incident surface and the fluorescent layer, wherein a concentration of the second reflection-prevent layer decreases as distance from the light-incident surface increases.

8. The light-emitting device of claim 7, wherein each of the first and second light-refractive index buffering particles includes at least one material selected from the group consisting of silicon dioxide (SiO₂), aluminum oxide (Al₂O₃), yttrium oxide (Y₂O₃), lanthanum oxide (La₂O₃) and titanium dioxide (TiO₂).

9. The light-emitting device of claim 8, wherein each of the first and second reflection-prevention layers has a thickness of about 50 nm to about 200 nm, and each of the first and second light-refractive index buffering particles has a size between about 15 nm to about 25 nm.

10. A method of manufacturing an optical element, the method comprising:
providing a colloidal solution including colloidal particles; and
solidifying the colloidal solution so that a concentration of the colloidal particles decreases as the distance from a first surface of a light-transmitting structure increases to form a first reflection-prevention layer that changes the light reflectance of the first surface.

11. The method of claim 10, wherein providing a colloidal solution comprises:
providing colloidal particles including at least one material selected from the group consisting of silicon dioxide (SiO₂), aluminum oxide (Al₂O₃), yttrium oxide (Y₂O₃), lanthanum oxide (La₂O₃) and titanium dioxide (TiO₂) that has sizes of 15 nm to about 25 nm; and
dispersing the colloidal particles in alcohol of about 5 weight percent to about 20 weight percent to manufacture the colloidal solution.

12. The method of claim 11, wherein forming the first reflection-prevention layer comprises:
dipping the light-transmitting structure into the colloidal solution;
removing the light-transmitting structure from the colloidal solution to form a colloidal solution layer on the first surface; and
drying the colloidal solution layer formed on the first surface to solidify the colloidal particles.

13. A method of manufacturing a light-emitting device, the method comprising:
dipping a lamp body having a lamp tube, a fluorescent layer formed on an interior surface of the lamp tube and discharge gas filled in the lamp tube into a colloidal solution;
removing the lamp body from the colloidal solution to form a colloidal solution layer on an exterior surface of the lamp tube; and
solidifying the colloidal solution formed on the exterior surface so that colloidal particles have a concentration that decreases with distance from the exterior surface , to form a first reflection-prevention layer.

14. The method of claim 13, further comprising providing the colloidal solution having one or more colloidal particles selected from the group consisting of silicon dioxide (SiO₂), aluminum oxide (Al₂O₃), yttrium oxide (Y₂O₃), lanthanum oxide (La₂O₃) and titanium dioxide (TiO₂), the colloidal particles having a size between about 15 nm and about 25 nm and being dispersed in alcohol to make up about 5 weight percent to about 20 weight percent of the colloidal solution.

15. A method of manufacturing a light-emitting device, the method comprising:
dipping a lamp tube having two open end portions into a colloidal solution having a plurality of colloidal particles, the colloidal particles including at least one material selected from the group consisting of silicon dioxide (SiO₂), aluminum oxide (Al₂O₃), yttrium oxide (Y₂O₃), lanthanum oxide (La₂O₃) and titanium dioxide (TiO₂);
removing the lamp tube from the colloidal solution to form a colloidal solution layer on an exterior surface and an interior surface of the lamp tube;
solidifying the colloidal solution layer so that a concentration of the colloidal particles decreases as the distances from the exterior and interior surfaces increase to form a first reflection-prevention layer and a second reflection-prevention layer;
forming a fluorescent layer on the second reflection-prevention layer formed on the interior surface; and
sealing the lamp tube having the fluorescent layer formed thereon and injecting a discharge gas into the lamp tube.
